# EUROPÄISCHE PATENTSCHRIFT

(11) **EP 2 837 935 B1**
(45) Veröffentlichungstag und Bekanntmachung des Hinweises auf die Patenterteilung: **05.09.2018**
(21) Anmeldenummer: 14179412.3
(22) Anmeldetag: 31.07.2014
(51) Int. Cl.: G01N 27/62, G01N 30/68, G01N 31/12

(54) **Verfahren zur Herstellung einer Funktionseinheit und entsprechende Funktionseinheit**
Method for producing a functional unit and functional unit
Procédé de fabrication d'une unité fonctionnelle et unité fonctionnelle correspondante

(30) Priorität: 01.08.2013 DE 102013012731
(43) Veröffentlichungstag der Anmeldung: 18.02.2015
(73) Patentinhaber: Krohne Messtechnik GmbH, 47058 Duisburg (DE)
(72) Erfinder: Kuipers, Winfred, 45130 Essen (DE)
(74) Vertreter: Gesthuysen Patent- und Rechtsanwälte

(56) Entgegenhaltungen:
- DE-C1- 19 814 659
- US-A- 3 762 878
- US-B1- 6 572 830
- US-B1- 6 592 696
- US-B1- 6 786 716

## Beschreibung

Die Erfindung betrifft eine Funktionseinheit mit einem Gaskonverter und einem Flammenionisationsdetektor. Der Gaskonverter dient dabei insbesondere der zumindest teilweisen Umwandlung eines Gases bzw. Gasgemischs als zu konvertierendem bzw. umzuwandelndem Medium.

Die Mikrosystemtechnik dient der Erzeugung von Strukturen oder Komponenten mit kleinsten Abmessungen.

Bei Niedertemperatur-Einbrand-Keramiken (Low Temperature Cofired Ceramics, LTCC) werden ungebrannte - sogenannte grüne - Keramikfolien einzeln strukturiert, gestapelt, laminiert (unter Laminieren sei dabei allgemein das Verbinden von Schichten mittels eines Klebers verstanden) und einem Sinterprofil bei einer Spitzentemperatur zwischen ca. 850 °C und 900 °C unterzogen. In den beim Sintern auftretenden maximalen Temperaturen unterscheidet sich das LTCC-Verfahren vom Erzeugen von Hochtemperatur-Einbrand-Keramiken (High Temperature Cofired Ceramics, HTCC), die bei Temperaturen zwischen 1600 °C und 1800 °C gesintert werden. Bekannt sind weiterhin Dickschicht-Hybridtechniken, wobei auf bereits gesinterte Keramiksubstrate Leiterbahnen oder Widerstände im Siebdruckverfahren aufgebracht werden. Wird der bedruckte Träger gebrannt, so verschmelzen die aufgebrachten Pasten zu Schichten. Anschließend findet ggf. eine Bestückung mit diskreten Bauteilen statt.

Eine Anwendung der Mikrosystemtechnik ist beispielsweise der Bereich der Erzeugung eines Flammenionisationsdetektors. Bei einem Flammenionisationsdetektor (FID) werden Kohlenwasserstoffe in einer Wasserstoffflamme ionisiert. Der Ionenstrom ist dann ein Maß für den organischen Kohlenstoffgehalt der zu untersuchenden Probe.

Eine Beschreibung eines Flammenionisationsdetektors findet sich in der WO 2009/036854 A1. Relevant sind in diesem Zusammenhang noch die Beschreibung eines Gegenstrombrenners in der WO 2011/015285 A2 bzw. eines Gegenstrombrenners für einen Flammenionisationsdetektor in der WO 2012/055835 A1.

Ein Verfahren zur Herstellung eines Flammenionisationsdetektors lässt sich der Patentanmeldung der Anmelderin mit Aktenzeichen DE 10 2012 015 204.3 entnehmen.

Beim Betrieb von Flammenionisationsdetektoren werden teilweise katalytische Gaskonverter oder Gasumformer - teilweise als Vorstufen - verwendet.

Wird normale Umgebungsluft als Brennluft verwendet, so lassen sich Spuren von organischen Verbindungen mittels thermischer Katalyse in CO₂ umsetzen. Dies geschieht beispielsweise, indem die Brennluft über einen Katalysator aus der Umgebung angesaugt wird.

Da weiterhin Methan als Spurengas zumeist in relativ hohen Konzentrationen in der Luft vorhanden ist (teilweise bis zu 1800 ppb in Relation zu 1 ppb für andere Kohlenwasserstoffe), wird unterschieden zwischen dem Gesamt-Kohlenwasserstoffgehalt und dem Methan-Kohlenwasserstoffgehalt. Um den Methan-Kohlenwasserstoffgehalt zu bestimmen, werden zunächst die übrigen organischen Verbindungen mittels katalytischer Oxidation entfernt.

Weiterhin lassen sich Kohlenstoffmonoxid CO und Kohlenstoffdioxid CO₂ mittels katalytischer Methanisierung quantifizieren, obgleich Flammenionisationsdetektoren prinzipiell unempfindlich gegenüber diesen Verbindungen sind. Die katalytische Methanisierung erfolgt dabei unter Zufuhr von Wasserstoff bei einer Temperatur zwischen 350 und 370 °C nach folgendem Schema:

CO + 3 H₂ → CH₄ + H₂O und CO₂ + 4 H₂ → CH₄ + 2 H₂O.

Es zeigt sich also der große Vorteil der Verwendung von Gaskonvertern in Verbindung mit Flammenionisationsdetektoren.

Miniaturisierte Konverter zur Umwandlung von flüssigem Methanol in Wasserstoff für Brennstoffzellen, die aus Mehrlagenkeramiken bestehen, lassen sich beispielsweise den Offenlegungsschriften US 2007/0154367 A1 oder WO 03/088390 A2 entnehmen.

Unterschiedliche Materialien für Katalysatoren zur Luftaufbereitung offenbart beispielsweise die DE 691 17 048 T2.

Katalysatoren für die Erzeugung von Nanoröhren für einen Gaschromatographen werden beispielsweise in der US 2007/0084346 A1 offenbart.

Aus der Druckschrift US 6,786,716 B1 ist eine Funktionseinheit mit einem Gaskonverter und einem Flammenionisationsdetektor bekannt.

Ein Flammenionisationsdetektor, dem katalytische Reaktoren vorgeschaltet sind, ist außerdem aus den Dokumenten US 3,762,878 und DE 198 14 659 C1 bekannt.

Mehrschichtige Struktur aus grünen Keramikfolien sowie deren Herstellungsverfahren sind aus den Dokumenten US 6,572,830 B1 und US 6,592,696 B1 bekannt.

Eine Schwierigkeit bei der Verwendung von Flammenionisationsdetektoren und Gaskonvertern, die sich insgesamt durch ihr Zusammenwirken als Funktionseinheit bezeichnen lassen, besteht in der Art der Anordnung und Verbindung der Komponenten. So muss beispielsweise eine sichere Übertragung für das vom Gaskonverter konvertierte Gas zum Detektor realisiert werden. Dies erhöht entsprechend auch die Anforderungen an die Anschlüsse des Detektors bzw. des Konverters. Weiterhin muss bei der Verwendung von gefährlichen Medien ausreichend Sicherheit gewährleistet werden.

Die Aufgabe der Erfindung besteht darin, ein eine Funktionseinheit mit einem Gaskonverter und einem Flammenionisationsdetektor vorzuschlagen, die in Erweiterung des Standes der Technik eine Verbesserung darstellt.

Ein Verfahren zur Herstellung einer Funktionseinheit mit einem Gaskonverter und einem Flammenionisationsdetektor ist zunächst und im Wesentlichen dadurch gekennzeichnet, dass der Gaskonverter und der Flammenionisationsdetektor zusammen in einer Mehrlagenkeramik erzeugt werden.
Der als Teil der Funktionseinheit entsprechend erzeugte Gaskonverter dient der zumindest teilweisen Umwandlung eines Gases bzw. Gasgemisches, von dem wenigstens eine Komponente zumindest teilweise - insbesondere unter Mitwirkung der mindestens einen Katalysatorschicht - zu konvertieren ist. Der erfindungsgemäße Gaskonverter ist also ein Mikro-Gaskonverter, der in einer Mehrlagenkeramik realisiert ist, die aus mehreren keramischen, zu einer Einheit verbundenen Lagen (alternative Bezeichnungen sind Schichten oder Ebenen) besteht. Indem der Gaskonverter und der Flammenionisationsdetektor zusammen in der Mehrlagenkeramik erzeugt werden, ergibt sich eine sehr kompakte Funktionseinheit. Ein großer Vorteil ist, dass sich so Schnittstellen innerhalb der Mehrlagenkeramik erzeugen lassen.

Dabei ist insbesondere der Gaskonverter dem Flammenionisationsdetektor funktional und auch räumlich vorgelagert. Als Methode zur Erzeugung von Gaskonverter und der Flammenionisationsdetektor werden in einer Ausgestaltung Mittel der Mikrosystemtechnik herangezogen.
In einer Ausgestaltung ist insbesondere vorgesehen, dass Abwärme des Flammenionisationsdetektors für die katalytischen Prozesse des Gaskonverters genutzt werden. So wird beispielsweise Wärme des Flammenionisationsdetektors durch entsprechende Strukturen durch den Gaskonverter geleitet.
Alternativ oder ergänzend ist auf oder in einer Lage der Mehrlagenkeramik als Teil des Gaskonverters mindestens eine Heizstruktur vorgesehen, um ebenfalls die Konvertierung mittels Katalyse zu steuern bzw. zu bewirken. Eine solche Heizstruktur wird beispielsweise mit einem elektrischen Strom beaufschlagt und erwärmt das zu konvertierende Medium bzw. die Katalysatorschicht.

In einer Ausgestaltung erfolgt die Herstellung der Funktionseinheit derart, dass mindestens ein Mediumsausgang des Gaskonverters mit dem Flammenionisationsdetektor verbunden ist.

Mediumsdurchgänge - z. B. in Form von Aussparungen, Löchern oder Bohrungen - sind in einer Ausgestaltung in dem Gaskonverter bzw. in Lagen der Mehrlagenkeramik vorgesehen. Dies dient auch dazu, um die Funktionseinheit als monolithische Mehrlagenkeramik zu realisieren und den Übergang des zu konvertierenden Gases bzw. Gasgemisches oder daran beteiligten Substanzen innerhalb der Mehrlagenkeramik zu erlauben.

Der obige Mediumsausgang des Gaskonverters ist damit - insbesondere in Verbindung mit einem Mediumseingang des Flammenionisationsdetektors - gleichzeitig ein Mediumsdurchgang innerhalb der Mehrlagenkeramik.

In einer Ausgestaltung sind insbesondere mehrere - identisch oder unterschiedlich ausgeführte - Gaskonverter in einer Mehrlagenkeramik angeordnet.

Insbesondere für die Herstellung des Gaskonverters wird in einer Ausgestaltung mindestens eine Katalysatorschicht auf einer Lage der Mehrlagenkeramik aufgebracht.

In einer Ausgestaltung ist vorgesehen, dass in mindestens einer Lage der Mehrlagenkeramik für den Gaskonverter mindestens eine Mediumsführungsbahn - insbesondere in Form einer Aussparung - erzeugt wird. Das geführte Medium ist dabei insbesondere ein Gas oder Gasgemisch.

In Verbindung mit der Mediumsführungsbahn ist in einer Ausgestaltung vorgesehen, dass die Katalysatorschicht und die Mediumsführungsbahn derartig erzeugt werden, dass die Mediumsführungsbahn ein Medium zumindest teilweise an der Katalysatorschicht vorbei führt. Durch den Kontakt mit der Katalysatorschicht findet eine chemische Umwandlung statt. Bei der Mediumsführungsbahn handelt es sich in einer Variante insbesondere um eine Aussparung in einer Lage der Mehrlagenkeramik.

In einer weiteren Ausgestaltung wird die Katalysatorschicht derartig - insbesondere derartig porös im Sinne von durchlässig für ein gasförmiges Medium - erzeugt, dass die Katalysatorschicht zumindest teilweise von einem - insbesondere von dem zu konvertierenden bzw. umzuwandelnden gasförmigen - Medium durchströmbar ist. In dieser Ausgestaltung strömt das Medium nicht durch eine Mediumsführungsbahn über die Katalysatorschicht hinweg, sondern strömt durch die Schicht selbst hindurch. Die Keramikschicht befindet sich wiederum in einer Mediumsführungsbahn. Hierfür wird die Katalysatorschicht beispielsweise mit einem Dickschichtverfahren auf einer Lage der Mehrlagenkeramik eingebracht.

Für die praktische Realisierung ist in einer Ausgestaltung vorgesehen, dass mindestens der Gaskonverter und der Flammenionisationsdetektor mittels LTCC- oder HTCC-Technik zumindest teilweise erzeugt werden. Daher werden die Strukturen oder Elemente des Gaskonverters bzw. des Flammenionisationsdetektors teilweise auf den grünen Keramiklagen der Mehrlagenkeramik erzeugt bzw. werden Aussparungen generiert und durch die anschließenden jeweils zugehörigen Prozesse der verwendeten Techniken werden diese Lagen bzw. Schichten gebrannt.

Die Erfindung bezieht sich auf eine Funktionseinheit mit mindestens einem Gaskonverter und mindestens einem Flammenionisationsdetektor, die gemäß einer der zuvor genannten Ausgestaltungen des Verfahrens hergestellt worden ist. So sind insbesondere der Gaskonverter und der Flammenionisationsdetektor zusammen in einer Mehrlagenkeramik erzeugt. Oder mit anderen Worten: Die Funktionseinheit besteht mindestens aus dem Gaskonverter und dem Flammenionisationsdetektor und wird insgesamt von der Mehrlagenkeramik gebildet.

Erfindungsgemäß ist mindestens ein Mediumsausgang des Gaskonverters mit dem Flammenionisationsdetektor verbunden. Die Verbindung ist derart, dass ein vom Gaskonverter konvertiertes Gas bzw. Gasgemisch dem Flammenionisationsdetektor zugeführt wird.

Erfindungsgemäß ist weiterhin vorgesehen, dass Abwärme des Flammenionisationsdetektors für katalytische Prozesse des Gaskonverters dient. In dieser Ausgestaltung wird also Wärme vom Flammenionisationsdetektor in den Gaskonverter geleitet.

Im Einzelnen gibt es eine Vielzahl von Möglichkeiten, das Verfahren und die erfindungsgemäße Funktionseinheit auszugestalten und weiterzubilden. Dazu wird verwiesen einerseits auf die dem Patentanspruch 1 nachgeordneten Patentansprüche, andererseits auf die folgende Beschreibung von Ausführungsbeispielen in Verbindung mit der Zeichnung. In der Zeichnung zeigen
- Fig. 1: eine schematische Darstellung eines Gaskonverters einer ersten Ausführung in Explosionsdarstellung,
- Fig. 2: eine schematische Darstellung einer Funktionseinheit mit einem Gaskonverter in einer zweiten Ausführung und mit einem Flammenionisationsdetektor in teilweiser Explosionsdarstellung,
- Fig. 3: eine schematische Darstellung einer Funktionseinheit mit einem Gaskonverter einer dritten Ausführung und mit einem Flammenionisationsdetektor in teilweiser Explosionsdarstellung und
- Fig. 4: zwei Schichten eines Gaskonverters in Draufsicht und als Schnitt.

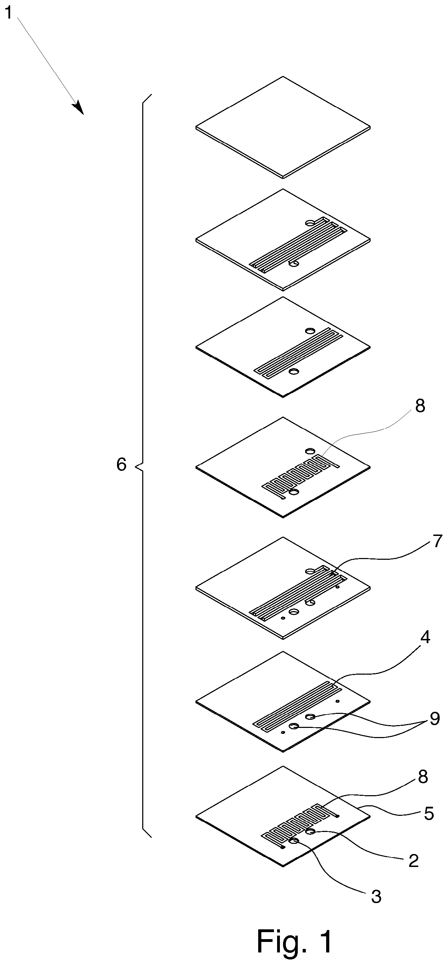

Die Fig. 1 zeigt in Explosionsdarstellung einen rein beispielhaft und für die Übersichtlichkeit der Darstellung stark reduzierten Gaskonverter 1. Auf der untersten Ebene befinden sich ein Mediumseingang 2 und ein Mediumsausgang 3, wobei das Medium insbesondere gasförmig ist. Durch die Anordnung von Ein- 2 und Ausgang 3 auf einer Seite des Gaskonverters 1 vereinfacht sich die Montage des Gaskonverters 1, der somit ggf. auch als SMD-Bauteil verwendet werden kann.

Für die Konvertierung bzw. Umwandlung des Gases als ein Medium sind Katalysatorschichten 4 vorgesehen, denen entlang das Gas strömt und wodurch das Gas bzw. Gasgemisch bzw. mindestens eine Komponente davon zumindest teilweise umgewandelt wird. Die Katalysatorschicht 4 befindet sich dabei auf einer der vielen Lagen 5 der Mehrlagenkeramik 6, die den Mikro-Gaskonverter 1 bildet.

In der gezeigten Ausgestaltung strömt das gasförmige Medium durch Mediumsführungsbahnen 7 hindurch und damit über die Katalysatorschichten 4 hinweg. Die Mediumsführungsbahnen 7 sind dabei insbesondere entsprechend ausgeführte Aussparungen in den jeweiligen Keramik-Lagen 5.

Auf anderen Lagen 5 befinden sich Heizstrukturen 8, die das Medium erwärmen und damit die Umwandlung unterstützen.

Nicht dargestellt sind die elektrischen Zuleitungen der Heizstrukturen 8, die teilweise durch die Lagen 5 hindurchgehen oder auch als elektrisch leitfähige Schichten auf den Lagen 5 aufgebracht worden sind. Die Zuleitungen sind vorzugsweise wie die fluidischen Zuführungen auf der Unterseite für eine SMD-Montage geführt. Solche fluidischen Zuführungen beziehen sich dabei allgemein auf die Zu- bzw. Abführung von Fluiden, also fließfähigen oder strömbaren, z. B. teilweise flüssigen oder gasförmigen Medien.

Für die Bewegung des Mediums zwischen den Lagen 5 sind Mediumsdurchgänge 9 in den Lagen 5 vorgesehen, die im gezeigten Beispiel als Bohrungen ausgeführt sind.

Auf den Lagen 5 des in der Fig. 1 gezeigten Gaskonverters 1 befinden sich - zeichnerisch von unten nach oben dargestellt - ein Heizelement 8, eine Katalysatorschicht 4 und darüber eine Mediumsführungsbahn 7, ein weiteres Heizelement 8 und darüber eine weitere Katalysatorschicht 4, an die eine Lage 5 mit einer Mediumsführungsbahn 7 angrenzt. Die oberste Lage ist dabei als Deckel ausgestaltet. Weiterhin befindet sich in den Lagen - außer in der Lage, die den Deckel darstellt - jeweils zwei Bohrungen als Mediumsdurchgänge 9: jeweils eine für das aufsteigende, noch zu konvertierende Gas und eine für das bereits umgewandelte Gas, das zum Mediumsausgang 3 geleitet wird.

Über den gezeigten Aufbau wird beispielsweise Umgebungsluft aufbereitet. Alternativ lassen sich - je nach Art der Katalysatorschichten - Kohlenstoff mono- und -dioxid umwandeln, um anschließend quantifiziert zu werden. Gleiches gilt auch für das Methan der Umgebungsluft.
Wie das Gas im Gaskonverter 1 geführt wird und wie weitere Stoffe oder Medien hinzu- oder abgeführt werden, lässt sich durch die Strukturierung der Lagen 5 erzielen, wobei teilweise auch Steuerelemente vorgesehen sein können, die z. B. Durchgänge für Medien öffnen oder schließen.

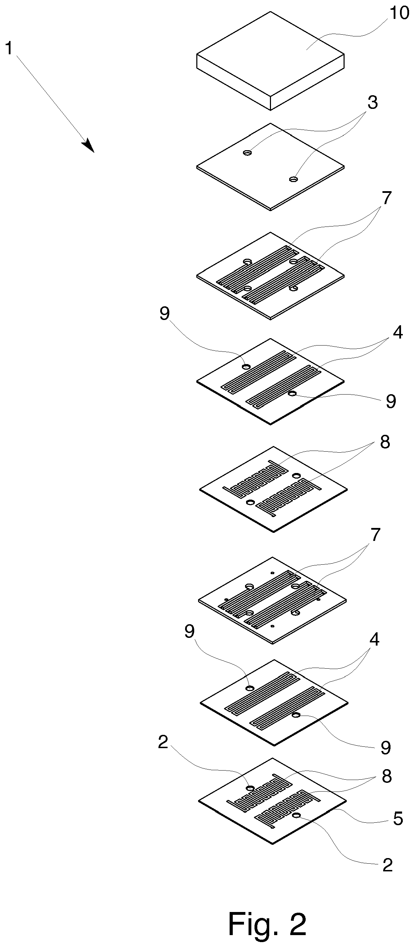

Die Fig. 2 zeigt eine Ausgestaltung, in der der Gaskonverter 1 direkt mit einem Flammenionisationsdetektor 10 verbunden ist und mit diesem insgesamt eine Mehrlagenkeramik 6 als Funktionseinheit bildet. Der Flammenionisationsdetektor 10 sei dabei insbesondere gemäß der Patentanmeldung der Anmelderin mit Aktenzeichen DE 10 2012 015 204.3 hergestellt. Die Lehre der vorgenannten Patentanmeldung sei dabei explizit zur Offenbarung der Ausgestaltung des Flammenionisationsdetektors der vorliegenden Patentanmeldung hinzugenommen.
Für die Verbindung zwischen den beiden funktionellen Einheiten Gaskonverter 1 und Flammenionisationsdetektor 10 führen zwei Mediumsausgänge 3 - für das konvertierte Gas - direkt zum Flammenionisationsdetektor 10. Die Strukturen und Funktionselemente des Gaskonverters 1 sind zudem zweifach auf jeder Lage 5 ausgeführt und liegen sich weitgehend spiegelsymmetrisch gegenüber. Durch die zwei Mediumseingänge 2 können damit auch unterschiedliche Medien eingebracht werden: z. B. das zu konvertierende Medium und ein Gas, das ggf. für spezielle Umwandlungen - z. B. nach dem Gegenstromverfahren - erforderlich ist. Weiterhin ist ggf. auch ein Ventil vor den Mediumseingängen 2 vorgesehen, so dass das Medium in unterschiedlicher Quantität gegenläufig den Gaskonverter 1 durchströmen kann.
Durch die direkte Verbindung zwischen Gaskonverter 1 und Flammenionisationsdetektor 10 wird eine sehr kompakte Bauweise für die sich daraus ergebende Funktionseinheit erzielt. Ein weiterer Vorteil ergibt sich durch die Führung der Abwärme des Flammenionisationsdetektors 10 durch den Gaskonverter 1, so dass die Abwärme zur Erwärmung des zu konvertierenden Gases dient. Die Führung geschieht beispielsweise über zusätzliche Bohrungen in den Lagen 5. Wird eine Bohrung mit einem guten thermischen Leiter - beispielsweise einem Metall - aufgefüllt, entsteht eine sogenannte "thermal via".

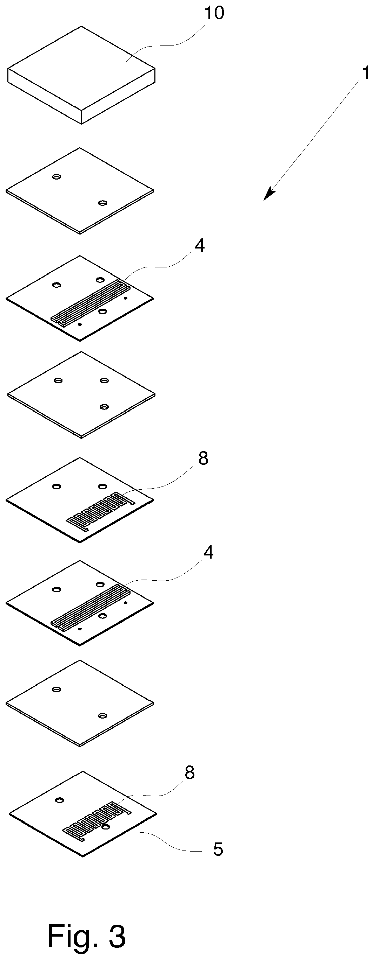

In der Ausgestaltung des Gaskonverters 1 der Fig. 3 durchströmt das Medium direkt die Katalysatorschichten 4, die hier entsprechend dicker und porös ausgeführt sind und die in den - hier nicht dargestellten - Mediumsführungsbahnen eingebracht sind.

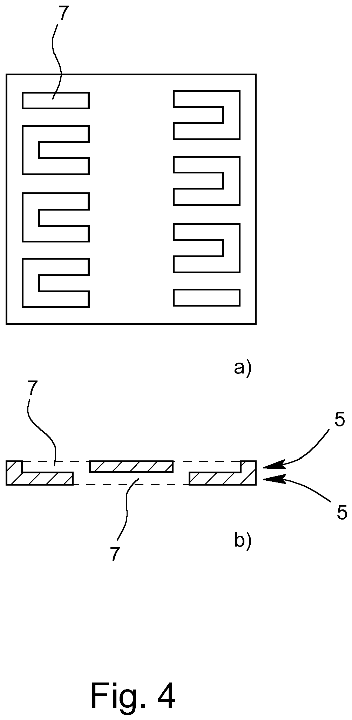

In der Fig. 4 sind unter a) eine Draufsicht und unter b) ein Schnitt durch eine Ausgestaltung einer besonders vorteilhaft ausgeführten und zwei Ebenen umfassenden Mediumsführungsbahn 7 dargestellt.

Die Mediumsführungsbahn 7 wird dabei insgesamt durch zwei Lagen 5 gebildet, in die die Aussparungen, die sich insgesamt zu den Bahnen 7 ergänzen, entsprechend eingebracht worden sind. Dies geschieht vorzugsweise in die grünen - d. h. noch ungesinterten Keramikschichten, die anschließend gesintert werden. Diese Ausführung zeichnet sich durch ihre erhöhte Stabilität aus.

Um die Stabilität zu erhöhen, kann eine Mediumsführungsbahn 7 auch - alternativ oder ergänzend - durch Einprägen in eine ungesinterte keramische Lage 5, die ggf. als Folie vorliegt, erzeugt werden (sog. Embossing).

## Patentansprüche

1. Funktionseinheit mit einem Gaskonverter (1) und einem Flammenionisationsdetektor (10), wobei der Gaskonverter (1) der zumindest teilweisen Umwandlung eines Gases oder Gasgemisches unter Mitwirkung mindestens einer Katalysatorschicht (4) dient und wobei der Gaskonverter (1) dem Flammenionisationsdetektor (10) funktional und räumlich vorgelagert ist,
**dadurch gekennzeichnet,**
**dass** der Gaskonverter (1) und der Flammenionisationsdetektor (10) zusammen in einer monolithischen Mehrlagenkeramik (6) erzeugt sind, wobei die Mehrlagenkeramik (6) aus mehreren keramischen, zu einer Einheit verbundenen Lagen (5) besteht, wobei mindestens ein Mediumsausgang (3) des Gaskonverters (1) als Mediumsdurchgang innerhalb der Mehrlagenkeramik (6) mit einem Mediumseingang des Flammenionisationsdetektors (10) zur Zuführung von konvertiertem Gas bzw. Gasgemisch verbunden ist und wobei Abwärme des Flammenionisationsdetektors (10) für katalytische Prozesse in den Gaskonverter (1) geleitet ist.

2. Funktionseinheit nach Anspruch 1, **dadurch gekennzeichnet, dass** in dem Gaskonverter (1) Mediumsführungsbahnen (7) und Katalysatorschichten (4) vorhanden sind, wobei das zu konvertierende Gas bzw. Gasgemisch durch die Mediumsführungsbahnen (7) über die Katalysatorschichten (4) hinweg strömt.

3. Funktionseinheit nach Anspruch 1, **dadurch gekennzeichnet, dass** in dem Gaskonverter (1) Mediumsführungsbahnen (7) und Katalysatorschichten (4) vorhanden sind, wobei die Katalysatorschichten (4) in den Mediumsführungsbahnen (7) eingebracht sind und wobei das zu konvertierende Gas bzw. Gasgemisch die Katalysatorschichten (4) durchströmt.

## Claims

1. Functional unit with a gas converter (1) and a flame ionization detector (10), wherein the gas converter (1) is used for at least partially converting a gas or gas mixture with the assistance of at least one catalyst layer (4) and wherein the gas converter (1) is functionally and spatially upstream from the flame ionization detector (10),
**characterized in**
**that** the gas converter (1) and the flame ionization detector (10) are produced together in a monolithic multi-layer ceramic (6), wherein the multi-layer ceramic (6) consists of a plurality of ceramic layers (5) combined into one unit, wherein at least one medium outlet (3) of the gas converter (1) as a medium passage within the multi-layer ceramic (6) is connected to a medium input of the flame ionization detector (10) for supplying converted gas or gas mixture and wherein waste heat of the flame ionization detector (10) is lead into the gas converter (1) for catalytic processes.

2. Functional unit according to claim 1, **characterized in that** medium guide paths (7) and catalyst layers (4) are provided in the gas converter (1), wherein the gas or gas mixture to be converted flows away through the medium guide paths (7) over the catalyst layers (4).

3. Functional unit according to claim 1, **characterized in that** medium guide paths (7) and catalyst layers (4) are provided in the gas converter (1), wherein the catalyst layers (4) are inserted in the medium guide paths (7) and wherein the gas or gas mixture to be converted flows through the catalyst layers (4).

## Revendications

1. Unité fonctionnelle comprenant un convertisseur de gaz (1) et un détecteur à ionisation de flamme (10), le convertisseur de gaz (1) servant à convertir au moins en partie un gaz ou un mélange de gaz par collaboration avec au moins une couche de catalyseur (4), et le convertisseur de gaz (1) étant monté avant le détecteur à ionisation de flamme (10) du point de vue fonctionnelle et physique,
**caractérisée en ce que**
le convertisseur de gaz (1) et le détecteur à ionisation de flamme (10) sont produits ensemble dans une céramique multicouche monolithique (6), la céramique multicouche (6) se composant de plusieurs couches céramiques (5) assemblées pour former une unité, au moins une sortie de milieu (3) du convertisseur de gaz (1) en tant que passage de milieu à l'intérieur de la céramique multicouche (6) étant connectée à une entrée de milieu du détecteur à ionisation de flamme (10) pour acheminer du gaz ou un mélange de gaz converti, et la chaleur perdue du détecteur à ionisation de flamme (10) et en conduite en vue de processus catalytiques dans le convertisseur de gaz (1).

2. Unité fonctionnelle selon la revendication 1, **caractérisée en ce que** des voies de guidage de milieu (7) et des couches de catalyseur (4) sont prévues dans le convertisseur de gaz (1), le gaz ou le mélange de gaz à convertir s'écoulant à travers les voies de guidage de milieu (7) au-delà des couches de catalyseur (4).

3. Unité fonctionnelle selon la revendication 1, **caractérisée en ce que** des voies de guidage de milieu (7) et des couches de catalyseur (4) sont prévues dans le convertisseur de gaz (1), les couches de catalyseur (4) étant introduites dans les voies de guidage de milieu (7) et le gaz ou le mélange de gaz à convertir traversant les couches de catalyseur (4).
